# EUROPÄISCHE PATENTSCHRIFT

(11) **EP 2 476 914 B1**
(45) Veröffentlichungstag und Bekanntmachung des Hinweises auf die Patenterteilung: **02.08.2017**
(21) Anmeldenummer: 11150865.1
(22) Anmeldetag: 13.01.2011
(51) Int. Cl.: F04D 29/58, H05K 7/20

(54) **Elektrische Kfz-Kühlmittelpumpe**
Electric vehicle coolant pump
Pompe électrique pour le refroidissement d'un moteur à combustion interne

(43) Veröffentlichungstag der Anmeldung: 18.07.2012
(73) Patentinhaber: Pierburg Pump Technology GmbH, 41460 Neuss (DE)
(72) Erfinder: Joschko, Witold, 47906 Kempen (DE); Gibat, Thomas Joachim, 47839 Krefeld (DE)
(74) Vertreter: Patentanwälte ter Smitten Eberlein-Van Hoof Rütten Partnerschaftsgesellschaft mbB

(56) Entgegenhaltungen:
- DE-A1-102007 054 060
- US-A1- 2007 206 357

## Beschreibung

Die Erfindung bezieht sich auf eine elektrische Kfz-Kühlmittelpumpe zur Versorgung eines Verbrennungsmotors mit Kühlmittel, wobei der bürstenlose Elektromotor elektronisch kommutiert wird.

Eine elektrische Kfz-Kühlmittelpumpe mit einem bürstenlosen elektronisch kommutierten Elektromotor als Antriebsmotor weist eine Steuerungs-Elektronik sowie Leistungs-Halbleiter auf, die im Betrieb Wärme erzeugen können. Eine Kühlmittelpumpe läuft während des Betriebes des mit Kühlmittel zu versorgenden Kfz-Verbrennungsmotors praktisch immer, wenn auch mit verschiedenen Geschwindigkeiten. Unter ungünstigen Bedingungen, beispielsweise bei Volllast des Verbrennungsmotors, geringer Kfz-Geschwindigkeit und hohen Außentemperaturen muss die Kühlmittelpumpe lange unter Volllast laufen. Hierbei muss die erhebliche Verlustwärme der Leistungs-Halbleiter zuverlässig abgeführt werden, um eine Zerstörung der Leistungs-Halbleiter zu verhindern.

Aus DE 10 2007 054 060 ist eine elektrische Kfz-Kühlmittelpumpe mit einem bürstenlosen Spalttopf-Elektromotor bekannt, bei der die Kühlfahnen der Leistungs-Halbleiter unmittelbar an der Trennwand anliegen, die den Nassbereich von einem Trockenbereich der Kühlmittelpumpe trennt. Zwar wird hierdurch eine gute Wärmeabfuhr von dem Leistungs-Halbleiter ermöglicht, jedoch ist die Kühlfahne elektrisch nicht unmittelbar mit einer Leiterbahn auf der Platine verbunden.

Aufgabe der Erfindung ist es in demgegenüber, eine elektrische Kfz-Kühlmittelpumpe mit einem elektronisch kommutierten Elektromotor zu schaffen, bei dem die Leistungs-Halbleiter gut gekühlt und die Kühlfahnen der Leistungs-Halbleiter unmittelbar mit einer Leiterbahn auf der Platine kontaktiert sind.

Diese Aufgabe wird erfindungsgemäß gelöst durch eine elektrische Kfz-Kühlmittelpumpe mit den Merkmalen des Patentanspruches 1.

Die Kühlmittelpumpe weist einen Nassbereich auf, in dem ein Pumpenrad und ein dauermagnetisch, also permanent erregter, Motorrotor des elektronisch kommutierten Elektromotors angeordnet sind. Ferner weist die Kühlmittelpumpe einen Trockenbereich auf, in dem unter anderem eine elektrische Platine angeordnet ist, die mehrere Leistungs-Halbleiter mit jeweils einer Kühlfahne trägt. Die Leistungs-Halbleiter dienen der direkten Ansteuerung der statorseitigen Motorspulen.

Der Nassbereich und der Trockenbereich sind durch eine elektrisch leitende und in einer Querebene liegende Trennwand voneinander getrennt. Die Trennwand ist bevorzugt aus elektrisch leitfähigem Metall, kann grundsätzlich aber auch aus elektrisch nicht-leitfähigem Material bestehen, beispielsweise aus Kunststoff. In einer Querebene liegend und benachbart zu der Trennwand ist eine Platine angeordnet, wobei die Leistungs-Halbleiter auf der der Trennwand zugewandten proximalen Seite der Platine angeordnet sind. Die elektrischen Anschlüsse der Leistungs-Halbleiter einschließlich der Kühlfahnen, die ebenfalls jeweils einen elektrischen Anschluss darstellen, sind mit entsprechenden Leiterbahnen auf der Platine verlötet.

Alle Kühlfahnen der Leistungs-Halbleiter sind jeweils auf einer eigenen Leiterbahn angeordnet und mit dieser verlötet, das heißt, die Kühlfahnen sind elektrisch voneinander getrennt. Die mit den Kühlfahnen verbundenen Leiterbahnen liegen mit ihren die Fläche der betreffenden Kühlfahne überragenden Bereichen auf der Trennwand auf, wobei zwischen der Trennwand und den Leiterbahn ein elektrisch nicht-leitendes Wärmeleitmittel vorgesehen ist, die die Leiterbahn von der Trennwand elektrisch isoliert, jedoch Wärme gut leitet. Als Wärmeleitmittel kommt insbesondere eine Wärmeleitfolie, eine Wärmeleitpaste oder ein Wärmeleitkleber in Frage.

Die Leiterbahn, auf der die Kühlfahne aufgelötet ist, muss also eine größere Fläche aufweisen als die Kühlfahne selbst, beziehungsweise als die mit der Leiterbahn verbundene Fläche der Kühlfahne. Nur der die Kühlfahne überragende Bereich der betreffenden Leiterbahn liegt auf dem elektrisch nicht-leitenden Wärmeleitmittel auf, das wiederum unmittelbar auf der Trennwand aufliegt. Auf der der Platine abgewandten Seite der Trennwand ist der Nassbereich, weshalb das dort zirkulierende Kühlmittel große Wärmemengen von der Trennwand abführen kann.

Der Wärmefluss der Abwärme des Leistungs-Halbleiters läuft also von seiner Kühlfahne über die Leiterbahn, auf der die Kühlfahne aufgelötet ist, und das elektrisch nicht-leitende Wärmeleitmittel zu der Trennwand, von wo aus die Wärme durch das Kühlmittel abgeführt wird. Auf diese Weise ist eine effektive Kühlung der Leistungs-Halbleiter möglich, wobei die Kühlfahnen der Leistungs-Halbleiter trotzdem jeweils mit einer eigenen Leiterbahn der Platine elektrisch verbunden beziehungsweise verlötet sind.

Vorzugsweise weist die Trennwand an ihrer der Platine zugewandten Seite für jeden Leistungs-Halbleiter jeweils eine Halbleiter-Ausnehmung auf, in die der Halbleiter axial hineinragt. Die Halbleiter-Ausnehmungen sind notwendig, damit die Trennwand mit ihrer Grundfläche, unter Zwischenschaltung des Wärmeleitmittels, unmittelbar auf der Leiterbahn aufliegen kann. Auf der der Trennwand zugewandten Seite der Platine sind ausschließlich die Leistungs-Halbleiter angeordnet, und sind keine anderen elektronischen Bauelemente vorgesehen. Besonders bevorzugt ist die gesamte Steuerungs-Elektronik zur Ansteuerung der Leistungs-Halbleiter auf der distalen, das heißt auf der der Trennwand abgewandten Seite, der Platine angeordnet. Für die Herstellung der elektrischen Verbindung der proximalen und der distalen Seite sind entsprechende Durchkontaktierungen vorgesehen, die jedoch ausschließlich den elektrischen Kontakt herstellen und nicht für Wärmetransport geeignet sind.

Vorzugsweise weist der Elektromotor einen Spalttopf auf, der den Nassbereich von einem Trockenbereich trennt, in dem unter anderem die statorseitigen Motorspulen angeordnet sind. Der Trockenbereich, in dem die Motorspulen angeordnet sind, kann getrennt von dem Trockenbereich sein, in dem die Platine angeordnet ist. Die in einer Querebene liegende Trennwand ist Teil des Spalttopfes, so dass die Trennwand unmittelbar durch das Kühlmittel angeströmt und gekühlt wird.

Gemäß einer bevorzugten Ausgestaltung ist die Fläche der Leiterbahn mindestens doppelt so groß, bevorzugt mindestens dreimal so groß, und besonders bevorzugt mindestens fünfmal so groß, wie die Fläche der jeweiligen Kühlfahne, mit der diese auf der Leiterbahn fixiert beziehungsweise verlötet ist. Je größer die Fläche der Leistungs-Halbleiter-Leiterbahn ist, desto größer ist die Fläche zum Abführen der Wärme von der Leiterbahn beziehungsweise desto größer kann die Berührungsfläche zwischen der Leiterbahn und dem Wärmeleitmittel beziehungsweise der Trennwand sein.

Im folgenden wird ein Ausführungsbeispiel der Erfindung anhand der Zeichnungen näher erläutert.

Es zeigen:
Figur 1 einen schematischen Längsschnitt einer Kfz-Kühlmittelpumpe mit einer Trennwand und einer Platine mit Leistungs-Halbleitern,
Figur 2 eine vergrößerte Darstellung der Trennwand und der Platine der Figur 1, und
Figur 3 eine Draufsicht auf die proximale Seite der Platine der Figuren 1 und 2.

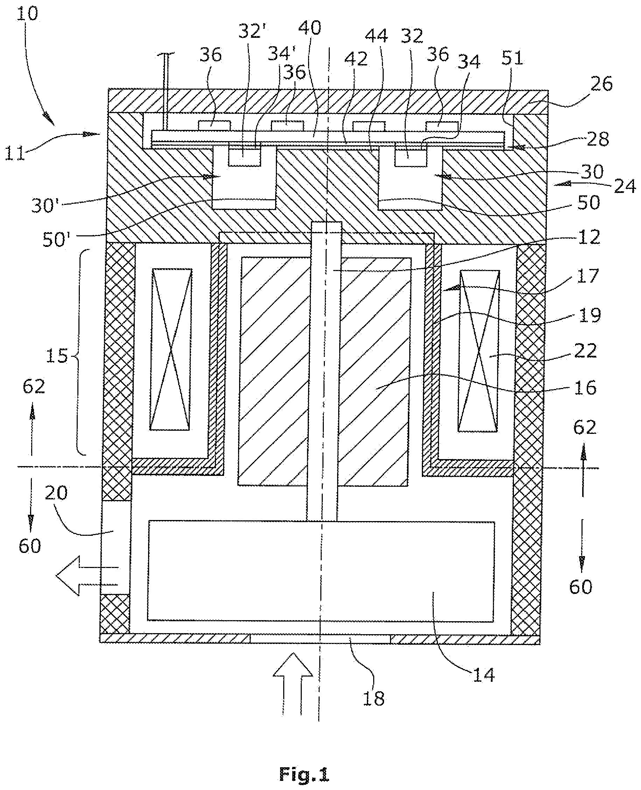

In der Figur 1 ist im Längsschnitt und schematisch eine elektrische Kfz-Kühlmittelpumpe 10 dargestellt, die ein flüssiges Kühlmittel in einem Kühlmittel-Kreislauf pumpt, der zur Kühlung eines nicht dargestellten Verbrennungsmotors dient. Die Kühlmittelpumpe 10 weist einen elektrischen bürstenlosen Antriebsmotor 15 auf, der elektronisch kommutiert wird.

Die Kühlmittelpumpe 10 weist ein mehrteiliges Gehäuse 11 auf, das innenseitig durch einen Spalttopf 17 in einen Nassbereich 60 und einen Trockenbereich 62 unterteilt ist. Der Spalttopf 17 wird durch eine im Querschnitt L-förmige nicht-magnetische Kunststoff-Topfhülse 19 und eine elektrisch leitende Metall-Trennwand 24 gebildet, die in einer Querebene liegt.

Der in dem Nassbereich 60 liegende Rotor weist eine zweifach gelagerte Welle 12, einen magnetisch permanent erregten Motorrotor 16 und einen Pumpenrotor 14 auf, der Kühlmittel von einem axialen Kühlmittel-Einlass 18 zu einem radialen Kühlmittel-Auslass 20 pumpt. In dem Trockenbereich 62 sind radial außerhalb des Motorrotors 16 und des zylindrischen Abschnittes der Topfhülse 19 und auf gleicher axialer Position mehrere Statorspulen 22 angeordnet, die auf der proximalen Seite der Trennwand 24 angeordnet sind.

Auf der distalen Seite der Trennwand 24 ist in einem Platinen-Raum 51 eine elektrische Platine 28 mit der gesamten Elektronik zur Ansteuerung der Statorspulen 19 vorgesehen. Die Platine 28 liegt in einer Querebene und ist beidseitig bestückt, wobei auf der distalen Seite der Platinen-Platte 40 mehrere Steuerungs-Elektronik-Elemente 36, die die Steuerungs-Elektronik 36 bilden, auf Leiterbahnen verlötet sind, und auf der proximalen Seite der Platine 28 ausschließlich mehrere identische Leistungs-Halbleiter 30,30' angeordnet sind, die über entsprechende Durchkontaktierungen 64 von der Steuerungs-Elektronik 36 angesteuert werden. Die Leistungs-Halbleiter 30,30' können MOSFET-Transistoren sein.

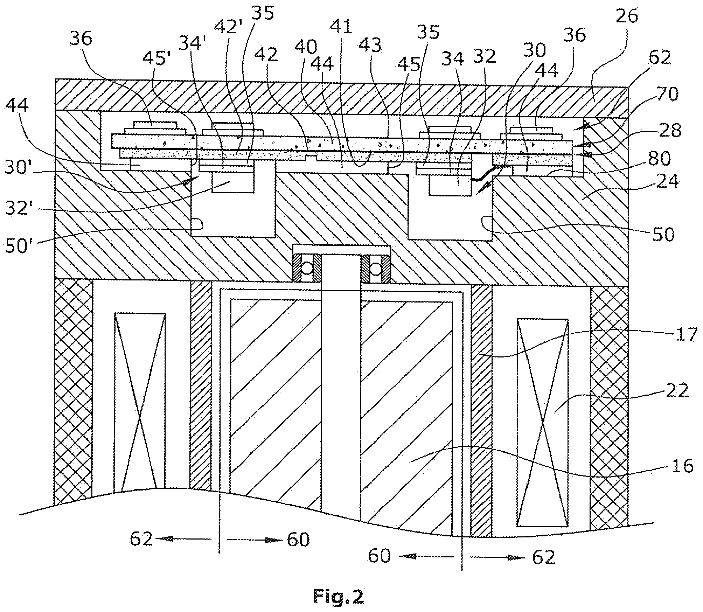

Wie insbesondere in der Figur 2 zu erkennen ist, sind die Leistungs-Halbleiter 30,30' liegend auf der Platine 28 montiert, wobei jeder Leistungs-Halbleiter 30,30' eine Kühlfahne 34 aufweist, deren Fläche größer ist als die entsprechende Fläche des Halbleiter-Körpers 32. Die Kühlfahne 34,34' ist jeweils ein elektrischer Anschluss des Leistungs-Halbleiters und ist vollflächig mit Lötzinn 35 jeweils auf einer großflächigen Leiterbahn 42,42' aufgelötet.

Die proximale Seite der Platine 28 ist mit einem elektrisch nicht-leitenden Wärmeleitmittel 44 in Form einer Wärmeleitfolie bedeckt, das lediglich in den Bereichen der Leistungs-Halbleiter 30,30' entsprechende Öffnungen 45,45' aufweist. Das Wärmeleitmittel 44 liegt auf der distalen Seite 80 der Trennwand 24 wärmeleitend auf, die jeweils im Bereich der Leistungs-Halbleiter 30,30' beziehungsweise der damit korrespondierenden Wärmeleitmittel-Öffnungen 45,45' entsprechenden Ausnehmungen 50,50' aufweist, in die der Halbleiter-Körper 32,32' jeweils hineinragt. Die Ausnehmungen 50,50' sind axial nicht durchgängig, so dass die Trennwand 24 vollständig flüssigkeitsdicht ist.

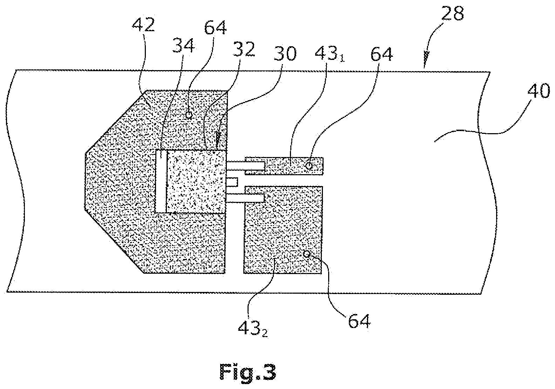

Um eine gute Wärmeleitung bzw. -ableitung sicherzustellen, beträgt die Fläche der Leiterbahn 42,42' jeweils mindestens das 4- bis 5-fache der Fläche der Kühlfahne 34,34' des betreffenden Leistungs-Halbleiters 30,30'. Wie in Figur 3 zu erkennen ist, sind auch die übrigen Anschlüsse des Leistungs-Halbleiters mit entsprechenden Leiterbahnen 43₁ und 43₂ verlötet.

Der Platinen-Raum 51 ist durch einen Deckel 26 verschlossen.

## Patentansprüche

1. Elektrische Kfz-Kühlmittelpumpe (10) mit
einem Nassbereich (60), in dem ein Pumpenrad (14) und ein permanent erregter Motorrotor (16) eines elektronisch kommutierten Elektromotors (15) angeordnet sind, und
einem Trockenbereich (62), in dem eine elektrische Platine (28) angeordnet ist, die mehrere Leistungs-Halbleiter (30,30') mit jeweils einer Kühlfahne (34,34') aufweist,
wobei der Nassbereich (60) und der Trockenbereich (62) durch eine in einer Querebene liegende Trennwand (24) voneinander getrennt sind, und
wobei die Leistungs-Halbleiter (30,30') auf der der Trennwand (24) zugewandten proximalen Seite (41) einer Platine (70) angeordnet sind,
**dadurch gekennzeichnet,**
**dass** die Kühlfahnen (34,34') jeweils auf einer eigenen Leiterbahn (42,42') der Platine (28) angeordnet sind, und
**dass** die Trennwand (24) auf ihrer der Platine (28) zugewandten Seite ein elektrisch nicht-leitendes Wärmeleitmittel (44) aufweist, das jeweils unmittelbar auf der Kühlfahnen-Leiterbahn (42, 42') aufliegt.

2. Elektrische Kfz-Kühlmittelpumpe (10) nach Anspruch 1, wobei die Trennwand (24) an ihrer der Platine (28) zugewandten Seite für jeden Leistungs-Halbleiter (30,30') jeweils eine Halbleiter-Ausnehmung (50,50') aufweist, in die der Leistungs-Halbleiter (30,30') axial hineinragt.

3. Elektrische Kfz-Kühlmittelpumpe (10) nach einem der vorangegangenen Ansprüche, wobei die Fläche der Kühlfahnen-Leiterbahn (42,42') mindestens doppelt so groß, bevorzugt mindestens dreimal so groß, besonders bevorzugt mindestens fünfmal so groß ist, wie die Fläche der jeweiligen Kühlfahne (34,34').

4. Elektrische Kfz-Kühlmittelpumpe (10) nach einem der vorangegangenen Ansprüche, wobei der Elektromotor (15) einen Spalttopf (17) aufweist, der den Nassbereich (60) von dem Trockenbereich (62) trennt.

5. Elektrische Kfz-Kühlmittelpumpe (10) nach einem der vorangegangenen Ansprüche, wobei die Platine (28) auf ihrer der Trennwand (24) abgewandten Seite die Steuerungs-Elektronik (36) zum Ansteuern der Leistungs-Halbleiter (30,30') aufweist.

## Claims

1. An electric coolant pump (10) for a motor vehicle, the electric coolant pump comprising:
a wet section (60) in which is arranged an impeller (14) and a permanently magnetized motor rotor (16) of an electronically commutated electromotor (15), and
a dry section (62) in which is arranged an electric circuit board (28) comprising a plurality of power semiconductors (30, 30') which each comprise a cooling lug (34, 34'),
the wet section (60) and the dry section (62) being separated from each other by a partition wall (24) lying in a traverse plane, and
the power semiconductors (30, 30') being each arranged on a proximal side of the electric circuit board (70) facing the partition wall (24),
**characterized in that**
each cooling lug (34, 34') is arranged on a separate conductor strip (42, 42') of the circuit board (28), and
on a side of the partition wall facing the electric circuit board (28), the partition wall (24) comprises a heat conductor means (44) which is configured to be electrically non-conductive, the heat conductor means being arranged to rest directly on the cooling lug conductor strip /42, 42').

2. The electric coolant pump (10) as recited in claim 1, wherein, on the side of the partition wall facing the circuit board (28), the partition wall (24) further comprises a semiconductor recess (50, 50') for each of the power semiconductors (30, 30'), into which recess a respective power semiconductor (30, 30') is arranged to extend axially.

3. The electric coolant pump (10) as recited in one of the preceding claims, wherein the surface area of the cooling lug conductor strip (42, 42') is at least twice, preferably at least three times, particularly preferred at least five times the size of the surface area of the respective cooling lug (34, 34').

4. The electric coolant pump (10) as recited in one of the preceding claims, wherein the electromotor (15) comprises a separating can (17) which is configured to separate the wet section (60) from the dry section (62).

5. The electric coolant pump (10) as recited in one of the preceding claims, wherein, on a side of the circuit board averted from the partition wall (24), the electric circuit board (28) further comprises control electronics (36) configured to drive the power semiconductors (30, 30').

## Revendications

1. Pompe électrique (10) pour le refroidissement d'un moteur à combustion interne, comportant
une zone humide (60), dans laquelle sont disposés une roue de pompe (14) et un rotor de moteur (16) d'un électromoteur (15) commuté électro-niquement, le rotor étant excité en permanence, et
une zone sèche (62) dans laquelle un circuit imprimé (28) électrique est disposé, qui comprend plusieurs semi-conducteurs de puissance (30, 30'), chacun avec une ailette de refroidissement (34, 34'),
ladite zone humide (60) et ladite zone sèche (62) étant séparées par une paroi de séparation (24) située dans un plan transversal, et
les semi-conducteurs de puissance (30, 30') étant disposés sur le côté proximal (41) d'un circuit imprimé (70) tourné vers la paroi de séparation (24),
**caractérisée en ce que**
les ailettes de refroidissement (34, 34') sont chacune disposées sur une propre piste conductrice (42, 42') du circuit imprimé (28), et
sur le côté tourné vers le circuit imprimé (28), la paroi de séparation (24) comporte un moyen conducteur thermique (44) électriquement non conducteur, ledit moyen restant directement sur la piste conductrice (42, 42').

2. Pompe électrique (10) pour le refroidissement d'un moteur à combustion interne selon la revendication 1, dans laquelle, sur le côté tourné vers le circuit imprimé (28), la paroi de séparation (24) présente un évidement à semi-conducteur (50, 50') pour chaque semi-conducteur de puissance (30, 30'), le semi-conducteur de puissance (30, 30') saillant axialement dans ledit évidement.

3. Pompe électrique (10) pour le refroidissement d'un moteur à combustion interne selon l'une quelconque des revendications précédentes, dans laquelle la surface de la piste conductrice (42, 42') d'une ailette de refroidissement est au moins deux fois, de préférence au moins trois fois, plus préférentiellement au moins cinq fois la surface de ladite ailette de refroidissement (34, 34') respective.

4. Pompe électrique (10) pour le refroidissement d'un moteur à combustion interne selon l'une quelconque des revendications précédentes, dans laquelle ledit électromoteur (15) comprend un pot d'entrefer (17) séparant ladite zone humide (60) de ladite zone sèche (62).

5. Pompe électrique (10) pour le refroidissement d'un moteur à combustion interne selon l'une quelconque des revendications précédentes, dans laquelle, sur le côté détourné de la paroi de séparation (24), le circuit imprimé (28) comporte l'électronique de commande (36) pour commander les semi-conducteurs de puissance (30, 30').
